# EUROPÄISCHE PATENTSCHRIFT

(11) **EP 1 341 239 B1**
(45) Veröffentlichungstag und Bekanntmachung des Hinweises auf die Patenterteilung: **01.04.2015**
(21) Anmeldenummer: 02004568.8
(22) Anmeldetag: 27.02.2002
(51) Int. Cl.: H01L 29/792

(54) **Ladungsabfangtransistor**
Charge trapping transistor
Transistor à piégeage de charges

(43) Veröffentlichungstag der Anmeldung: 03.09.2003
(73) Patentinhaber: Infineon Technologies AG, 85579 Neubiberg (DE)
(72) Erfinder: Atti, Massimo, 81369 München (DE); Schulz, Thomas, 81737 München (DE); Specht, Michael, Dr., 80799 München (DE); Hofmann, Franz, Dr., 80995 München (DE)
(74) Vertreter: Repkow, Ines

(56) Entgegenhaltungen:
- WO-A-02/11145
- DE-A- 19 612 676
- US-A1- 2001 002 712
- US-A1- 2001 029 076
- HORIGUCHI N ET AL: "A Direct Tunneling Memory (DTM) utilizing novel floating gate structure" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5. Dezember 1999 (1999-12-05), Seiten 922-924, XP010372205 ISBN: 0-7803-5410-9

## Beschreibung

Die vorliegende Erfindung betrifft eine Vorrichtung gemäß dem Oberbegriff des Patentanspruchs 1, d.h. einen Transistor mit einem Source-Abschnitt, einem Drain-Abschnitt, einem Gate-Abschnitt, und einem Floating Gate.

Ein solcher Transistor kann als Speichertransistor in nichtflüchtigen Speichern eingesetzt werden.

Nichtflüchtige Speicher sind in einer Vielzahl unterschiedlichster Ausführungsformen bekannt. Zu den bekannten nichtflüchtigen Speichern gehören beispielsweise PROMs, EPROMs, EEPROMs, Flash-Speicher, SONOS etc. Die verschiedenen nichtflüchtigen Speicher unterscheiden sich hinsichtlich der Programmierbarkeit, der Umprogrammierbarkeit, der Programmierzeit, der Speicherdichte, der Herstellungskosten etc.

Für diverse Anwendungen hat ein geringer Herstellungspreis die höchste Priorität. Darüber hinaus ist es häufig wünschenswert, daß der Speicher wie beispielsweise ein OTP-ROM (one time programmable ROM) wenigstens einmal elektrisch programmierbar ist, unter Verwendung niedriger elektrischer Spannungen programmierbar ist, eine Haltezeit von ca. 10 Jahren hat, und kompatibel mit heutiger CMOS-Technik ist.

Ein Transistor, der die genannten Forderungen am ehesten zu erfüllen scheint, ist ein nach dem SONOS-Konzept hergestellter Transistor wie er in Boaz Eitan, Paolo Pavan, Ilan Bloom, Efraim Aloni, Aviv Frommer, und David Finzi: "NROM: A Novel Localized Trapping, 2-Bit Nonvolatile Memory Cell", IEEE Electron Device Letters, Vol. 21, No. 11, November 2000, Seiten 543 - 545 beschrieben ist.

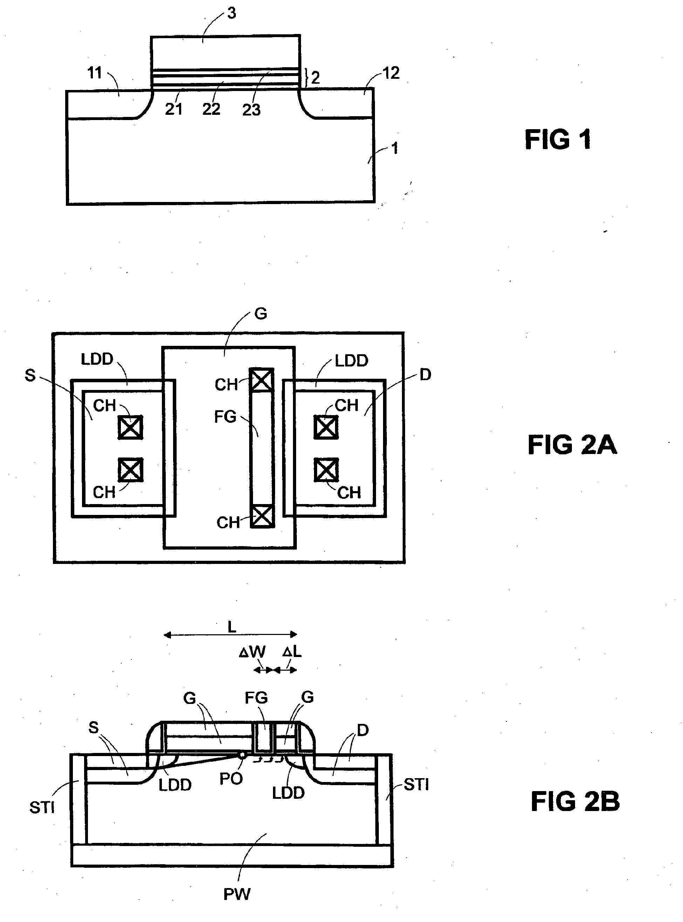

Der prinzipielle Aufbau eines solchen Transistors ist schematisch in Figur 1 dargestellt.

Der in der Figur 1 gezeigte Transistor ist auf bzw. in einem Substrat 1 angeordnet, und enthält einen im Substrat 1 ausgebildeten Source-Abschnitt 11, einen ebenfalls im Substrat 1 ausgebildeten Drain-Abschnitt 12, einen im Bereich zwischen dem Source-Abschnitt 11 und den Drain-Abschnitt 12 auf dem Substrat angeordneten ONO-Stack 2, und einen auf dem ONO-Stack angeordneten Gate-Abschnitt 3. Der erwähnte ONO-Stack besteht aus einer auf dem Substrat 1 angeordneten Oxid-Schicht 21, einer auf der Oxid-Schicht 21 angeordneten Nitrid-Schicht 22, und einer auf der Nitrid-Schicht angeordneten Oxid-Schicht 22.

Die Nitrid-Schicht 22 des ONO-Stack ONO wird als Floating Gate verwendet; in ihm kann durch einen Programmiervorgang ein Elektronenüberschuß erzeugt werden.

Die Erzeugung eines Elektronenüberschusses in der Nitrid-Schicht 22 erfolgt durch die Injektion sogenannter channel hot electrons (CHE), welche bei geeigneter Ansteuerung des Transistors in dem zwischen dem Source-Abschnitt 11 und dem Drain-Abschnitt 12 liegenden Substratbereich entstehen. Diese channel hot electrons sind so energiereich, daß sie die Oxid-Schicht 21 passieren, und sich dann in der Nitrid-Schicht 22 einlagern. Durch die Einlagerung der channel hot electrons werden in der Nitrid-Schicht 22 die sogenannten Traps gefüllt.

Die gefüllten Traps haben eine Veränderung der Threshold-Spannung des Transistors zur Folge, und diese Veränderung der Threshold-Spannung ermöglicht es, beim Auslesen des Transistors festzustellen, ob der Transistor programmiert wurde oder nicht. Wie das Auslesen von Speichertransistoren genau erfolgt, ist bekannt und bedarf keiner näheren Erläuterung.

Der beschriebene Transistor kann unter Verwendung von Spannungen programmiert werden, die relativ klein sind. Die beim Programmieren verwendeten Spannungen sind insbesondere erheblich kleiner als die Spannungen, die zum Programmieren der sehr weit verbreiteten Transistoren erforderlich sind, bei welchem das Floating Gate durch eine elektrisch leitende Schicht gebildet wird, und der Transfer von Ladungsträgern zum bzw. vom Floating Gate durch Fowler Nordheim Tunneln erfolgt.

"A direct tunneling memory (DTM) utilizing novel floating gate structure" von N.Horiguchi et al., IEDM Technical Digest 1999, Seiten 922-924, zeigt einen Speichertransistor in dem das Floating Gate in einer Aussparung des Gate-Abschnittes vorgesehen ist.

In dem o.g. Aufsatz von Boaz Eitan et al. ist angegeben, daß ein Programmieren des dort beschriebenen Transistors bei einer Source-Spannung von 0 V, einer Drain-Spannung von 4,5 V, und einer Gate-Spannung von 9 V erfolgen kann.

Obgleich diese Spannungen schon relativ niedrig sind, ist es aus verschiedenen Gründen wünschenswert, mit noch kleineren Spannungen auskommen zu können. Ferner wäre es wünschenswert, die Herstellung eines solchen Transistors zu vereinfachen, und insbesondere - bezogen auf einen Standard-CMOS-Herstellungsprozeß ohne zusätzliche Masken oder zumindest mit möglichst wenigen zusätzlichen Masken auszukommen.

Der vorliegenden Erfindung liegt daher die Aufgabe zugrunde, einen Transistor gemäß dem Oberbegriff des Patentanspruchs 1 zu schaffen, der einfacher herstellbar ist und mit geringeren Spannungen programmierbar ist als es bei herkömmlichen Transistoren dieser Art der Fall ist.

Diese Aufgabe wird erfindungsgemäß durch den in Patentanspruch 1 beanspruchten Transistor gelöst.

Der erfindungsgemäße Transistor zeichnet sich dadurch aus, daß das Floating Gate in einer Aussparung des Gate-Abschnittes vorgesehen ist, und daß die Entfernung der Aussparung zum Dran-Abschnitt geringer ist als die Entfernung der Aussparung zum Source-Abschnitt.

Durch die veränderte Anordnung des Floating Gate kann der Abstand zwischen dem Gate-Abschnitt und dem den Transistor tragenden Substrat verringert werden, und damit kann auch die an den Gate-Abschnitt anzulegende Spannung kleiner gewählt werden als bei herkömmlichen Transistoren, insbesondere noch kleiner als bei dem von Boaz Eitan et al. beschriebenen Transistor gewählt werden.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: den Aufbau eines herkömmlichen Transistors mit einem Floating Gate,
- Figur 2A: eine Draufsicht auf den im folgenden beschriebenen Transistor,
- Figur 2B: eine Seitenansicht des im folgenden beschriebenen Transistors,
- Figuren 3A bis 3J: verschiedene Stadien der Herstellung des in den Figuren 2A und 2B gezeigten Transistors,
- Figur 4: den Aufbau eines Transistors, dessen Gate-Abschnitt eine besonders schmale Aussparung für das Floating Gate aufweist, und
- Figur 5: den Aufbau eines Transistors, der zwei Floating Gates aufweist.

Der im folgenden beschriebene Transistor ist Bestandteil einer integrierten Schaltung. Bei der integrierten Schaltung handelt es sich im betrachteten Beispiel um einen Mikrocontroller, und der Transistor bildet hier eine Speicherzelle oder ist Bestandteil einer Speicherzelle eines OTP-Speichers. Der Transistor kann jedoch auch Bestandteil einer beliebigen anderen Komponente des Mikrocontrollers sein, und kann auch in anderen integrierten Schaltungen als Mikrocontrollern vorgesehen werden. Darüber hinaus kann ein Transistor, der die Besonderheiten des nachfolgend beschriebenen Transistors aufweist, auch in normalen, d.h. nicht integrierten Schaltungen eingesetzt werden.

Der Aufbau des im folgenden beschriebenen Transistors ist in den Figuren 2A (Draufsicht) und 2B (Querschnitt) gezeigt.

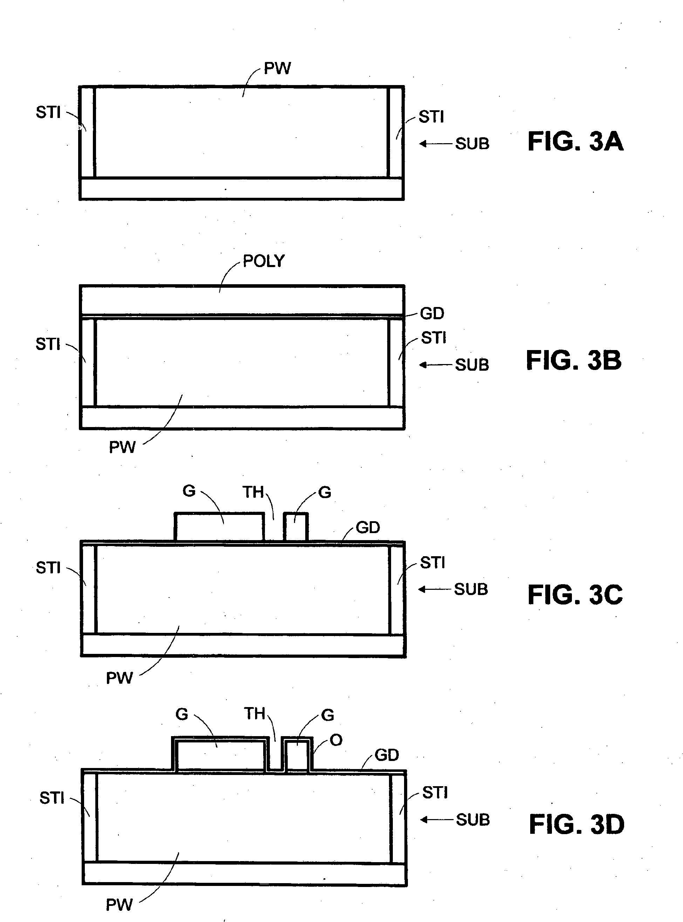

Der Aufbau des Transistors läßt sich anhand der Vorgehensweise bei der Herstellung desselben besser verstehen. Deshalb wird, bevor auf die Besonderheiten des in den Figuren 2A und 2B gezeigten Transistors eingegangen wird, unter Bezugnahme auf die Figuren 3A bis 3J die Herstellung desselben beschrieben.

Ausgangspunkt der Transistorherstellung ist ein durch ein Siliziumplättchen gebildetes Substrat. Im Substrat wird zunächst durch p-Dotierung desselben eine p-Wanne ausgebildet. Danach, oder auch schon davor, wird im Substrat um den Bereich herum, den der Transistor nach der Herstellung desselben auf dem Substrat belegen wird, eine sogenannte Shallow Trench Isolation ausgebildet. Hierzu wird in das Substrat ein den Transistor-Bereich umgebender Graben geätzt, welcher anschließend mit einem Oxid aufgefüllt wird. Die Shallow Trench Isolation dient zur lateralen Isolation des herzustellenden Transistors gegenüber seitlich benachbarten Schaltungselementen.

Der so weit hergestellte Transistor ist in Figur 3A veranschaulicht. Dabei ist das Substrat mit SUB, die p-Wanne mit PW, und die Shallow Trench Isolation mit STI bezeichnet.

Danach wird das Substrat SUB mit einem beispielsweise durch eine Siliziumdioxid-Schicht gebildeten Gate-Dielektrikum beschichtet. Der Vollständigkeit halber sei angemerkt, daß das Gate-Dielektrikum auch durch ein anderes dielektrisches Material gebildet werden kann.

Auf das Gate-Dielektrikum wird eine Polysilizium-Schicht aufgebracht, von welcher ein Teil den Gate-Abschnitt des Transistors bilden wird. Der Vollständigkeit halber sei angemerkt, daß statt Polysilizium auch anderes Metall oder eine Metalllegierung verwendet werden kann.

Der so weit hergestellte Transistor ist in Figur 3B veranschaulicht. Dabei ist das Gate-Dielektrikum bildende Schicht mit GD bezeichnet, und die Polysilizium-Schicht mit POLY bezeichnet.

Danach werden die nicht benötigten Teile der Polysilizium-Schicht POLY entfernt. Was nach dem Entfernen der nicht benötigten Teile der Polysilizium-Schicht POLY übrig bleibt, ist der Gate-Abschnitt des Transistors. Der Gate-Abschnitt unterscheidet sich allerdings von den Gate-Abschnitten herkömmlicher Transistoren: er weist eine Aussparung auf, welche später mit einem Nitrid gefüllt wird.

Der so weit hergestellte Transistor ist in Figur 3C veranschaulicht. Dabei ist der nicht entfernte, den Gate-Abschnitt bildende Teil der Polysilizium-Schicht POLY mit G bezeichnet, und die darin vorgesehene Aussparung mit TH

Wie insbesondere aus der Figur 2A ersichtlich ist, weist die Aussparung TH im betrachteten Beispiel die Form eines langen schmalen Rechtecks auf, dessen Längsseite parallel zu dem zu diesem Zeitpunkt noch nicht ausgebildeten Drain-Abschnitt des Transistors verläuft. Die Aussparung befindet sich nahe beim Drain-Abschnitt, zumindest aber in wesentlich geringerer Entfernung zum Drain-Abschnitt als zum Source-Abschnitt, und liegt ferner oberhalb des Substrat-Bereiches, in welchem während des Programmierens des Transistors channel hot electrons entstehen. Die Aussparung TH ist einerseits so schmal, daß der Gate-Abschnitt im Betrieb des Transistors auch auf den unter der Aussparung liegenden Substrat-Bereich einwirken kann, und ist andererseits so lang und breit, daß sich beim Programmieren des Transistors möglichst viele channel hot electrons in das später in die Aussparung eingebrachte Nitrid einlagern können. Wichtig ist ferner, daß sich die Längsseite der Aussparung über die gesamte Länge der parallel zu dieser verlaufenden Seite des Drain-Abschnittes erstreckt, und daß die Polysilizium-Schicht POLY in der Aussparung TH bis zum Gate-Dielektrikum GD entfernt ist.

Danach wird auf die in der Figur 3C gezeigte Anordnung eine Oxid-Schicht aufgebracht. Das Aufbringen dieser Oxid-Schicht kann durch thermische Oxidation (TOX) erfolgen, und eventuell zusätzlich durch eine Abscheidung von TEOS (Tetraäthylorthosilikat).

Der so weit hergestellte Transistor ist in Figur 3D veranschaulicht. Dabei ist die Oxid-Schicht mit O bezeichnet.

Das Aufbringen der Oxid-Schicht O ist ein optionaler Schritt, der eventuell entfallen kann. Im allgemeinen erweist sich das Aufbringen der Oxid-Schicht O jedoch als vorteilhaft. Dies hat zwei Gründe. Der erste Grund besteht darin, daß das Gate-Dielektrikum GD dort, wo die Polysilizium-Schicht POLY entfernt wurde, teilweise mitentfernt sein worden könnte und einer Ausbesserung bedarf. Der zweite Grund besteht darin, daß dadurch die Dicke des Materials (GD), das zwischen dem Substrat SUB und dem Gate-Abschnitt G vorhanden ist, und die Dicke des Materials (GD + O), das zwischen dem Substrat SUB und dem später in die Aussparung TH eingebrachten Nitrid G vorhanden ist, unabhängig voneinander frei wählbar sind. Dadurch kann die zwischen dem Gate-Abschnitt G und dem Substrat SUB vorhandene Gate-Dielektrikums-Schicht GD besonders dünn ausgebildet werden, und dies hat den positiven Effekt, daß der Transistor mit besonders geringen Gate-Spannungen betrieben werden kann.

Nach dem Aufbringen der Oxid-Schicht O werden die Bereiche des Substrats, in welchen später der Source-Abschnitt und der Drain-Abschnitt des Transistors ausgebildet werden, durch eine sogenannte LDD-Implantation schwach n-dotiert. Dadurch entstehen im Substrat schwach n-dotierte Bereiche.

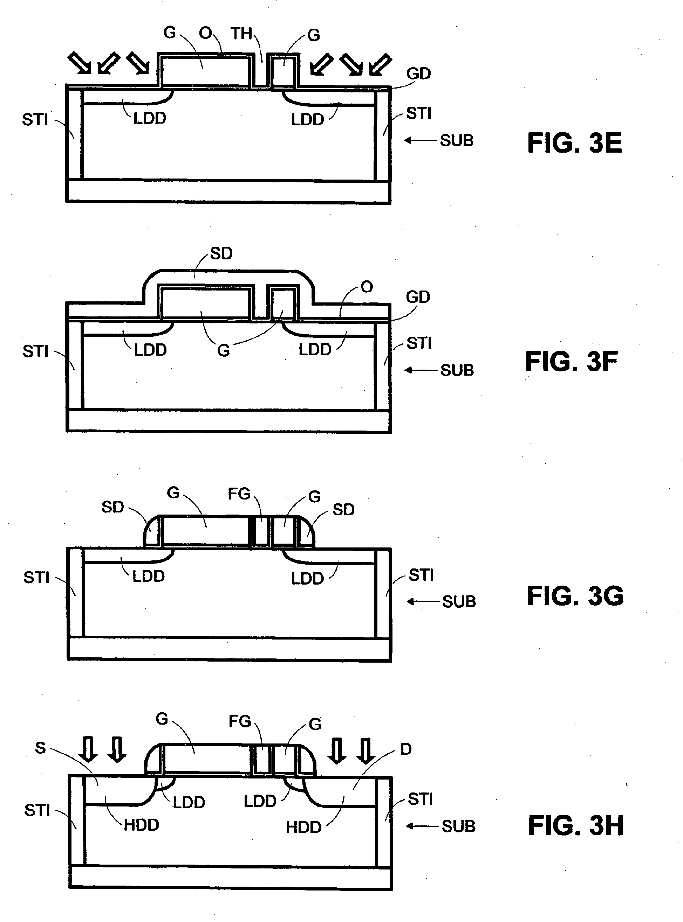

Der so weit hergestellte Transistor ist in Figur 3E veranschaulicht. Dabei sind die durch die LDD-Implantation erzeugten n-dotierten Bereiche mit LDD bezeichnet.

Bei der LDD-Implantation und/oder bei der Plazierung der Aussparung TH im Gate-Abschnitt G des Transistors ist darauf zu achten, daß der n-dotierte Bereich LDD sich nicht bis unter die Aussparung TH erstreckt.

Im nächsten Schritt wird auf die in der Figur 3E gezeigte Anordnung eine Schicht aus einem dielektrischem Material mit Störstellenzentren aufgebracht. Die Störstellenzentren sind innerhalb des dielektrischen Materials vorhandene Stellen, an welchen sich die channel hot electrons einlagern können, die sich während des Programmierens des Transistors unterhalb der Aussparung im Substrat bilden. Das verwendete dielektrische Material wird in der Regel mit dem Fachbegriff charge trapping device bezeichnet, und wird im folgenden in Anlehnung an die Verwendung desselben als Speicher-Dielektrikum bezeichnet. Vorliegend wird als Speicher-Dielektrikum ein Nitrid verwendet. Als Speicher-Dielektrikum könnte aber auch ein beliebiges anderes Material mit vergleichbaren Eigenschaften verwendet werden.

Die mit einer Speicher-Dielektrikums-Schicht beschichtete Anordnung ist in Figur 3F gezeigt. Die Speicher-Dielektrikums-Schicht ist dabei mit dem Bezugszeichen SD bezeichnet.

Bei der Beschichtung der Anordnung mit dem Speicher-Dielektrikum SD wird auch die Aussparung TH vollständig mit Speicher-Dielektrikum ausgefüllt.

Im Anschluß an das Aufbringen der Speicher-Dielektrikums-Schicht SD werden Teile derselben wieder entfernt. Nicht entfernt werden lediglich das in der Aussparung TH befindliche Speicher-Dielektrikum, sowie ein als Spacer bezeichneter, den Gate-Abschnitt G seitlich umlaufender schmaler Streifen des Speicher-Dielektrikums. Bei der Entfernung der Speicher-Dielektrikums-Schicht werden auch die dabei freigelegten Teile der Schichten GD und O entfernt.

Der so weit hergestellte Transistor ist in Figur 3G veranschaulicht. Der in der Aussparung TH verbleibende Teil des Speicher-Dielektrikums SD bildet ein Floating Gate des Transistors.

Anschließend werden durch eine sogenannte HDD-Implantation der Source-Abschnitt und der Drain-Abschnitt des Transistors ausgebildet. Bei der HDD-Implantation werden die Bereiche, des Substrats SUB, welche den Source-Abschnitt und den Drain-Abschnitt des Transistors bilden sollen, stark n-dotiert.

Der so weit hergestellte Transistor ist in Figur 3H veranschaulicht. Dabei sind die durch die HDD-Implantation erzeugten stark n-dotierten Bereiche mit HDD bezeichnet, und der den Source-Abschnitt bildende HDD-Bereich zusätzlich mit S, und der den Drain-Abschnitt bildende HDD-Bereich zusätzlich mit D.

Im Anschluß daran erfolgt eine Silizidierung der Kontaktbereiche. Dadurch wird die Leitfähigkeit der betreffenden Bereiche verbessert.

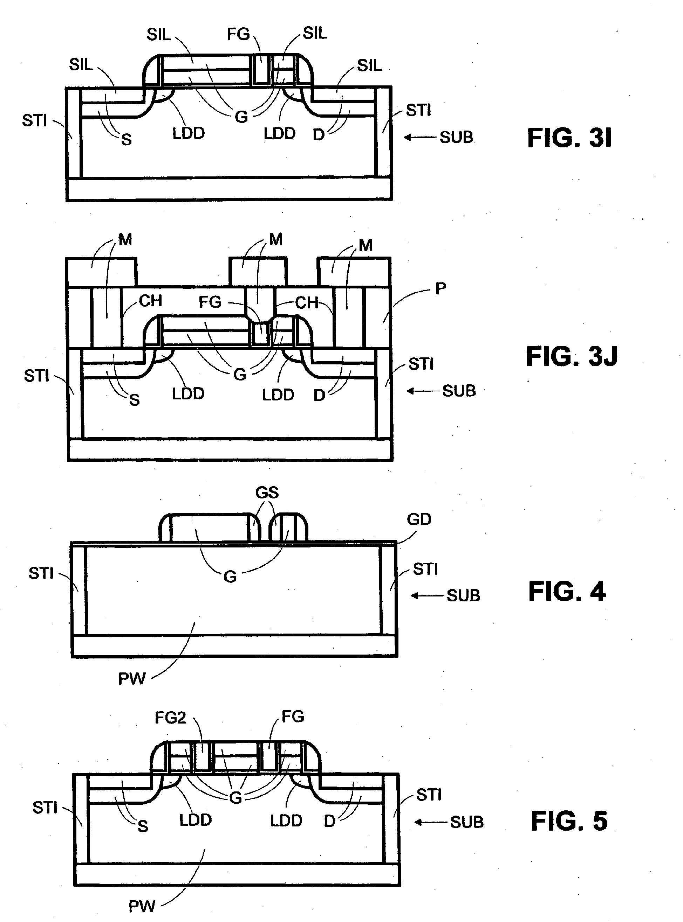

Der so weit hergestellte Transistor ist in Figur 3I veranschaulicht. Die silizidierten Teile der Anordnung sind mit SIL bezeichnet.

Danach wird auf die Anordnung eine beispielsweise durch ein Oxid gebildete Schicht zur Passivierung aufgebracht.

Die Passivierungs-Schicht wird an den Stellen, an welchen der Source-Abschnitt S, der Drain-Abschnitt D, und der Gate-Abschnitt G kontaktiert werden sollen, wieder entfernt. Danach wird auf die Anordnung eine Metall-Schicht aufgebracht, wobei auch die zuvor in der Passivierungs-Schicht gebildeten Kontaktlöcher mit Metall gefüllt werden.

Abschließend werden die nicht benötigten Teile der Metallschicht wieder entfernt.

Die in den Kontaktlöchern verbleibenden Teile der Metall-Schicht bilden Durchkontaktierungen bzw. Kontakte zur Kontaktierung des Source-Abschnittes S, des Drain-Abschnittes D, und des Gate-Abschnittes G; die auf der Passivierungs-Schicht verbleibenden Teile der Metall-Schicht bilden Leiterbahnen zur elektrischen Verbindung des Transistors mit anderen Komponenten der den Transistor enthaltenden Schaltung.

Damit ist die Herstellung des Transistors beendet. Der fertige Transistor ist in Figur 3J gezeigt. Dabei sind die Passivierungs-Schicht mit P bezeichnet, die Kontaktlöcher mit CH, und die Metallschicht mit M.

Wie aus der Figur 2A ersichtlich ist, sind zur Kontaktierung des Source-Abschnittes S, des Drain-Abschnittes D, und des Gate-Abschnittes G jeweils zwei Kontakte vorgesehen. Für die verschiedenen Abschnitte können jedoch unabhängig voneinander auch mehr oder weniger Kontakte vorgesehen werden.

Es wird nun unter Bezugnahme auf die Figuren 2A und 2B die Funktion des Transistors beschrieben. Der Vollständigkeit halber sei angemerkt, daß der in der Figur 2B gezeigte Transistor aus Gründen der Übersichtlichkeit nicht der in der Figur 3J gezeigte fertig hergestellte Transistor ist, sondern nur die in der Figur 3I gezeigte Vorstufe.

Beim Programmieren des Transistors werden an den Source-Abschnitt S und den Drain-Abschnitt D solche Spannungen angelegt, daß die Source-Drain-Spannung größer als die sogenannte Pinch-Off-Spannung ist. Die Pinch-Off-Spannung ist diejenige Spannung, bei welcher der Transistor vom linearen Bereich in den Sättigungsbereich übergeht. Wenn die Source-Drain-Spannung größer als die Pinch-Off-Spannung ist, gibt es längs des elektrisch leitenden Kanals, der sich zwischen dem Source-Abschnitt S und dem Drain-Abschnitt D ausbildet, einen sogenannten Pinch-Off-Punkt PO. Dieser Pinch-Off-Punkt PO ist der Punkt, an welchem sich die Pinch-Off-Spannung einstellt. Die Source-Drain-Spannung des zu programmierenden Transistors wird nun so gewählt, daß sich zwischen dem Source-Abschnitt S und dem Pinch-Off-Punkt PO Spannungen einstellen, die kleiner sind als die Pinch-Off-Spannung, und daß sich zwischen dem Pinch-Off-Punkt PO und den Drain-Abschnitt D Spannungen einstellen, die größer sind als die Pinch-Off-Spannung, wobei der unterhalb des Speicher-Dielektrikums SD liegende Bereich des leitenden Kanals, zu dem Kanalteil gehört, in welchem sich die oberhalb der Pinch-Off-Spannung liegende Spannungen einstellen, und wobei der Pinch-Off-Punkt PO wie in der Figur 2B gezeigt möglichst nahe beim Speicher-Dielektrikum SD liegt. In dem Bereich des leitenden Kanals, in welchem sich oberhalb der Pinch-Off-Spannung liegende Spannungen einstellen, also auch in dem unter dem Speicher-Dielektrikum SD liegenden Kanalbereich, entstehen durch Ionisation channel hot electrons. Diese channel hot electrons werden bei geeigneter Wahl der an den Gate-Abschnitt G angelegten Spannung nach oben aus dem leitenden Kanal herausgezogen. Sie passieren die Gate-Dielektrikums-Schicht GD und die Oxid-Schicht O und lagern sich im Speicher-Dielektrikum SD ein.

Durch die Einlagerung von Elektronen im Speicher-Dielektrikum SD verschieben sich die Kennlinien des Transistors. Insbesondere verändert sich dadurch die Threshold-Spannung, d.h. die Gate-Source-Spannung oder die Gate-Drain-Spannung, bei welcher der Transistor vom nicht leitenden Zustand in den leitenden Zustand gelangt.

Die Spannungen, die während des Programmierens des Transistors an diesen angelegt werden, hängen von den Abmessungen und Proportionen desselben ab, unter anderem vom Abstand L zwischen dem Source-Abschnitt S und dem Drain-Abschnitt D, sowie von der Größe des Speicher-Dielektrikums SD (insbesondere von dessen Breite ΔW) und von der Lage des Speicher-Dielektrikums SD innerhalb des Gate-Abschnittes G (insbesondere von dessen Entfernung ΔL zum drainseitigen Rand des Gate-Abschnittes G.

Bei entsprechender Dimensionierung des Transistors dürften die zu verwendenden Spannungen in etwa den Spannungen entsprechen, die an den herkömmlichen Transistor anzulegen sind, der in dem eingangs erwähnten Aufsatz von Boaz Eitan et al. beschrieben ist. Wie eingangs bereits erwähnt wurde, wird an diesen herkömmlichen Transistor während des Programmierens an den Source-Abschnitt eine Spannung von 0 V angelegt, an den Drain-Abschnitt eine Spannung von 4,5 V, und an den Gate-Abschnitt eine Spannung von 9 V.

Beim vorstehend beschriebenen Transistor dürfte allerdings insbesondere die zu verwendende die Gate-Drain-Spannung, und damit auch die zu verwendende Gate-Spannung erheblich geringer sein als es bei dem von Boaz Eitan et al. beschriebenen Transistor der Fall ist. Dies liegt daran, weil der Gate-Abschnitt G des beschriebenen Transistors einen viel geringeren Abstand zum Substrat SUB hat als es bei dem von Boaz Eitan et al. beschriebenen Transistor der Fall ist. Bei dem vorstehend beschriebenen Transistor ist der Gate-Abschnitt G nämlich nur durch die Gate-Dielektrikums-Schicht GD vom Substrat SUB getrennt, wobei, wie vorstehend bereits erwähnt wurde, die Dicke dieser Schicht obendrein unabhängig von der Dicke des Materials ist, das zwischen dem Speicher-Dielektrikum SD und dem Substrat SUB vorgesehen werden muß. Im Gegensatz hierzu ist bei dem von Boaz Eitan et al. beschriebenen Transistor der Gate-Abschnitt durch den ONO-Stack 2 vom Substrat getrennt, wobei allein schon die untere Oxid-Schicht 11 des ONO-Stack mindestens so dick (oder dicker) sein muß wie die Gate-Dielektrikums-Schicht GD des vorliegend beschriebenen Transistors; die Oxid-Schicht 11 muß eine gewisse Mindest-Dicke aufweisen, damit verhindert wird, daß sich in die Nitrid-Schicht 12 Elektronen einlagern, die die Oxid-Schicht 11 durch Tunneln überwunden haben.

Beim Auslesen des Transistors wird dieser in umgekehrter Richtung betrieben wie beim Programmieren. D.h. es wird an den Drain-Abschnitt D eine Spannung von 0 V angelegt, und an den Source-Abschnitt eine positive Spannung. Dadurch erreicht man eine optimale Wirkung des Speicher-Dielektrikums auf die Thresholdspannung des Transistors.

Die Spannungen, die während des Auslesens des Transistors an diesen angelegt werden, hängen unter von den Abmessungen und Proportionen desselben ab. Bei entsprechender Dimensionierung des Transistors dürften die zu verwendenden Spannungen in etwa den Spannungen entsprechen, die an den herkömmlichen Transistor anzulegen sind, der in dem eingangs erwähnten Aufsatz von Boaz Eitan et al. beschrieben ist. An diesen herkömmlichen Transistor werden während des Auslesens an den Source-Abschnitt eine Spannung von 1,5 V angelegt, an den Drain-Abschnitt eine Spannung von 0 V, und an den Gate-Abschnitt eine Spannung von 3 V. Aus den vorstehend genannten Gründen dürfte die zu verwendende die Gate-Source-Spannung, und damit auch die zu verwendende Gate-Spannung geringer sein als es bei dem von Boaz Eitan et al. beschriebenen Transistor der Fall ist.

Der vorstehend beschriebene Transistor ist einfacher herstellbar und mit geringeren Spannungen betreibbar als es bei dem von Boaz Eitan et al. beschriebenen Transistor der Fall ist.

Der vorstehend beschriebene Transistor bzw. dessen Herstellung kann in einigen Punkten zur Erzielung weiterer Vorteile modifiziert werden.

Eine der möglichen Modifikationen besteht darin, daß ausgehend von dem in der Figur 3C gezeigten Zustand zumindest entlang der Längsseiten der Aussparung TH aus dem selben Material wie der Gate-Abschnitt bestehende Spacer aufgetragen werden. Durch diese Spacer verringert sich die Breite ΔW der Aussparung TH, wodurch sich eine verbesserte Wirkung des Gate-Abschnittes auf den unterhalb der Aussparung liegenden Substratbereich erzielen läßt.

Eine Anordnung mit solchen Spacern ist in Figur 4 gezeigt. Die Spacer sind dabei mit dem Bezugszeichen GS bezeichnet.

Eine weitere mögliche Modifikation besteht darin, daß in der Nähe des Source-Abschnittes S eine zweite Aussparung im Gate-Abschnitt G vorgesehen wird, welche mit einem Speicher-Dielektrikum gefüllt wird. Dadurch können im beschriebenen Transistor wie bei dem von Boaz Eitan et al. beschriebenen herkömmlichen Transistor zwei Bits pro Transistor gespeichert werden.

Ein solcher Transistor ist in Figur 5 gezeigt. Die zweite Aussparung ist mit dem Bezugszeichen TH2 bezeichnet.

Die zweite Aussparung ist in dem in der Figur 5 gezeigten Zustand bereits mit Speicher-Dielektrikum SD gefüllt. Das in der zweiten Aussparung TH2 vorhandene Dielektrikum wirkt als zweites Floating Gate FG2.

Für die Abmessungen und die Anordnung dieses zweiten Floating Gate gelten die zum ersten Floating Gate FG gemachten Ausführungen entsprechend.

Bezüglich der Art und Weise, auf welche ein Speichertransistor zur Speicherung von zwei Bits anzusteuern ist, wird auf den eingangs erwähnten Aufsatz von Boaz Eitan et al. verwiesen. Die dort zu diesem Punkt gemachten Ausführungen gelten für den in der Figur 5 gezeigten Transistor entsprechend.

### Bezugszeichenliste

- 1: Substrat
- 2: ONO-Stack
- 3: Gate-Abschnitt
- 11: Source-Abschnitt
- 12: Drain-Abschnitt
- 21: Oxid-Schicht
- 22: Nitrid-Schicht
- 23: Oxid-Schicht

- CH: Kontaktloch
- D: Drain-Abschnitt
- FG: Floating Gate
- FG2: Floating Gate
- G: Gate-Abschnitt
- GD: Gate-Dielektrikum
- GS: Spacer
- HDD: stark n-dotierter Bereich
- LDD: leicht n-dotierter Bereich
- M: Metall-Schicht
- O: Oxid-Schicht
- P: Passivierungs-Schicht
- PO: Pinch-Off-Punkt
- POLY: Polysilizium-Schicht
- PW: p-Wanne
- S: Source-Abschnitt
- SD: Speicher-Dielektrikum
- SIL: silizidierter Bereich
- SUB: Substrat
- STI: Shallow Trench Isolation
- TH: Aussparung

## Patentansprüche

1. Transistor mit einem Source-Abschnitt, einem Drain-Abschnitt, einem Gate-Abschnitt, und einem Floating Gate, wobei das Floating Gate an einer zwischen dem Source-Abschnitt und dem Drain-Abschnitt liegenden Stelle in einer Aussparung des Gate-Abschnittes vorgesehen ist,
**dadurch gekennzeichnet**,
daß die Entfernung der Aussparung zum Drain-Abschnitt geringer ist als die Entfernung der Aussparung zum Source-Abschnitt.

2. Transistor nach Anspruch 1,
**dadurch gekennzeichnet**,
**daß** das Floating Gate aus dielektrischem Material mit die Einlagerung von Elektronen gestattenden Störstellen besteht.

3. Transistor nach Anspruch 1 oder 2,
**dadurch gekennzeichnet,**
**daß** das Floating Gate durch ein Nitrid gebildet wird.

4. Transistor nach einem der vorhergehenden Ansprüche
**dadurch gekennzeichnet**,
**daß** die Aussparung des Gate-Abschnittes, in welcher das Floating Gate vorgesehen ist, den Gate-Abschnitt von oben bis unten durchläuft.

5. Transistor nach einem der vorhergehenden Ansprüche,
**dadurch gekennzeichnet,**
daß die Aussparung des Gate-Abschnittes, in welcher das Floating Gate vorgesehen ist, lang und schmal ist.

6. Transistor nach Anspruch 5,
**dadurch gekennzeichnet,**
**daß** die Aussparung so schmal ist, daß die die Aussparung umgebenden Gate-Bereiche auf den unterhalb der Aussparung liegenden Substrat-Bereich wirken können.

7. Transistor nach Anspruch 6,
**dadurch gekennzeichnet,**
**daß** die Längsseite der Aussparung parallel zum Drain-Abschnitt verläuft.

8. Transistor nach Anspruch 7,
**dadurch gekennzeichnet**,
daß sich die Längsseite der Aussparung über die gesamte Länge der parallel zu dieser verlaufenden Seite des Drain-Abschnittes erstreckt.

9. Transistor nach einem der vorhergehenden Ansprüche,
**dadurch gekennzeichnet,**
**daß** die Aussparung über einem Substratbereich liegt, in welchem während des Programmierens des Transistor channel hot electrons entstehen.

10. Transistor nach einem der vorhergehenden Ansprüche,
**dadurch gekennzeichnet,**
**daß** zwischen dem Gate-Abschnitt und dem darunter liegenden Substratbereich und zwischen dem Floating Gate und dem darunter liegenden Substratbereich jeweils eine Schicht vorgesehen ist, wobei die zwischen dem Gate-Abschnitt und dem darunter liegenden Substratbereich vorhandene Schicht dünner ist als die zwischen dem Floating Gate und dem darunter liegenden Substratbereich liegende Schicht.

11. Transistor nach einem der vorhergehenden Ansprüche,
**dadurch gekennzeichnet,**
**daß** der Gate-Abschnitt über einen Kontakt kontaktiert ist, der sowohl mit einem diesseits der Aussparung liegenden Bereich des Gate-Abschnittes als auch mit einem jenseits der Aussparung liegenden Bereich des Gate-Abschnittes elektrisch verbunden ist.

## Claims

1. Transistor having a source section, a drain section, a gate section, and a floating gate, wherein the floating gate is provided at a location situated between the source section and the drain section in a cutout of the gate section,
**characterized in that**
the distance between the cutout and the drain section is smaller than the distance between the cutout and the source section.

2. Transistor according to Claim 1,
**characterized in that**
the floating gate consists of dielectric material having defects which allow the incorporation of electrons.

3. Transistor according to Claim 1 or 2,
**characterized in that**
the floating gate is formed by a nitride.

4. Transistor according to any of the preceding claims,
**characterized in that**
the cutout of the gate section, in which cutout the floating gate is provided, passes through the gate section from top to bottom.

5. Transistor according to any of the preceding claims,
**characterized in that**
the cutout of the gate section, in which cutout the floating gate is provided, is long and narrow.

6. Transistor according to Claim 5,
**characterized in that**
the cutout is so narrow that the gate regions surrounding the cutout can act on the substrate region situated below the cutout.

7. Transistor according to Claim 6,
**characterized in that**
the longitudinal side of the cutout runs parallel to the drain section.

8. Transistor according to Claim 7,
**characterized in that**
the longitudinal side of the cutout extends over the entire length of that side of the drain section which runs parallel thereto.

9. Transistor according to any of the preceding claims,
**characterized in that**
the cutout is situated above a substrate region in which channel hot electrons arise during the programming of the transistor.

10. Transistor according to any of the preceding claims,
**characterized in that**
a layer is in each case provided between the gate section and the underlying substrate region and between the floating gate and the underlying substrate region, while the layer present between the gate section and the underlying substrate region is thinner than the layer lying between the floating gate and the underlying substrate region.

11. Transistor according to any of the preceding claims,
**characterized in that**
the gate section is contacted via a contact which is electrically connected both to a region of the gate section that lies on this side of the cutout and to a region of the gate section that lies on the other side of the cutout.

## Revendications

1. Transistor comportant une section de source, une section de drain, une section de grille et une grille flottante, dans lequel la grille flottante est disposée à une position située entre la section de source et la section de drain dans un évidement de la section de grille,
**caractérisé en ce que** la distance de l'évidement à la section de drain est inférieure à la distance de l'évidement à la section de source.

2. Transistor selon la revendication 1,
**caractérisé en ce que** la grille flottante est constituée d'un matériau diélectrique avec incorporation d'impuretés donnant des électrons.

3. Transistor selon la revendication 1 ou 2,
**caractérisé en ce que** la grille flottante est formée par un nitrure.

4. Transistor selon l'une quelconque des revendications précédentes,
**caractérisé en ce que** l'évidement de la section de grille dans laquelle est disposée la grille flottante traverse la section de grille du haut vers le bas.

5. Transistor selon l'une quelconque des revendications précédentes, **caractérisé en ce que** l'évidement de la section de grille dans laquelle est disposée la grille flottante est long et étroit.

6. Transistor selon la revendication 5,
**caractérisé en ce que** l'évidement est si étroit que les régions de grille entourant l'évidement peuvent agir sur la région de substrat se trouvant en dessous de l'évidement.

7. Transistor selon la revendication 6,
**caractérisé en ce que** le côté longitudinal de l'évidement s'étend parallèlement à la section de drain.

8. Transistor selon la revendication 7,
**caractérisé en ce que** le côté longitudinal de l'évidement s'étend sur toute la longueur du côté de la section de drain orienté parallèlement à celui-ci.

9. Transistor selon l'une quelconque des revendications précédentes,
**caractérisé en ce que** l'évidement se trouve sur une région de substrat dans laquelle apparaissent des électrons chauds de canal pendant la programmation du transistor.

10. Transistor selon l'une quelconque des revendications précédentes,
**caractérisé en ce que**, entre la section de grille et la région de substrat sous-jacente à celle-ci et entre la grille flottante et la région de substrat sous-jacente à celle-ci, est disposée une couche respective, la couche présente entre la section de grille et la région de substrat sous-jacente à celle-ci étant plus mince que la couche se trouvant entre la grille flottante et la région de substrat sous-jacente à celle-ci.

11. Transistor selon l'une quelconque des revendications précédentes,
**caractérisé en ce qu'**un contact est établi avec la section de grille par l'intermédiaire d'un contact qui est à la fois électriquement connecté à une région de la section de grille se trouvant en deçà de l'évidement et à une région de la section de grille se trouvant au-delà de l'évidement.
